# EUROPEAN PATENT SPECIFICATION

(11) **EP 0 734 055 B1**
(45) Date of publication and mention of the grant of the patent: **26.07.2000**
(21) Application number: 96107414.3
(22) Date of filing: 09.11.1992
(51) Int. Cl.: H01L 21/00

(54) **Method of manufacturing an electrostatic chuck**
Verfahren zur Herstellung einer elektrostatischen Halteplatte
Méthode de fabrication d'un support électrostatique

(30) Priority: 07.11.1991 US 789222
(43) Date of publication of application: 25.09.1996
(62) Divisional of application: 92310212.3
(73) Proprietor: Varian Semiconductor Equipment Associates Inc., Gloucester, MA 01930 (US)
(72) Inventor: Sherman, Arthur, Palo Alto, California 94304 (US)
(74) Representative: Cline, Roger Ledlie

(56) References cited:
- EP-A- 0 360 529
- EP-A- 0 439 000
- EP-A- 0 452 222
- PATENT ABSTRACTS OF JAPAN vol. 8, no. 247 (E-278) [1684] , 13 November 1984 & JP-A-59 124140 (FUJITSU K.K.), 18 July 1984,

## Description

This application is divided from European Patent Application (EP-A-0541400) which pertains to the field of holding a workpiece, such as a semiconductor wafer, to a chuck in a low pressure environment by electrostatic forces, in such manner that when the electrostatic forces are removed, the workpiece does not adhere to the chuck. The present invention is concerned with the manufacture of such a chuck.

The invention is set out in claim 1.

An example of the invention will now be described with reference to the accompanying drawing, in which:

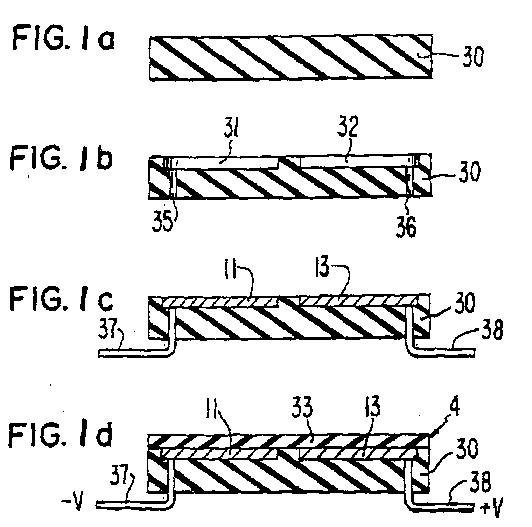

Figure 1 (a-d) illustrates a series of four steps in the manufacture of an electrostatic chuck.

The chuck to be made may or may not be a chuck of the type described in Figs. 1-3 of the parent application (EP-A-0541400). For purposes of illustration only, a chuck of the parent application Fig. 2-3 variety is shown. A lower dielectric element 30 and an upper dielectric element 33 are used. Lower dielectric 30 should be thicker than upper dielectric 33. Lower dielectric 30 needs to be relatively thick for purposes of mechanical support and to avoid the bowing of a workpiece held on the chuck in applications where heating is involved. Upper dielectric 33 must be relatively thin because of the need to maximize the electrostatic forces pulling on the workpiece. The trade-off is that if upper dielectric 33 is made to be too thin, it could crack, which would lead to undesirable arcing. For a sapphire dielectric 33, a desirable thickness is between 0.13 and 0.26 mm (5 mils and 10 mils). To achieve such a thin layer, lapping rather than grinding is called for.

Figure 1(b) illustrates a preferred embodiment, in which recesses 31,32 are ground or lapped out of the upper surface of lower dielectric 30. Holes 35, 36 are drilled through dielectric 30 into recesses 31,32, respectively, to accommodate means for coupling to voltage sources -V and +V.

The recesses 31,32 are filled with brazing compound 11,13, as illustrated in Figure 1(c). The holes 35,36 can either be filled with brazing compound or, as illustrated in Fig. 1(c), support the ends of wires 37,38 which are electrically connected to the patches 11,13 of brazing compound, respectively, and protrude downwardly from dielectric 30.

The upper dielectric 33 is then placed onto the assembly of Figure 1(c) and the new assembly is heated above the melting point of the brazing compound. Upon cooling, surfaces 30 and 33 are brazed together, and electrodes 11,13 are automatically formed. The wires 37,38 are then connected to voltage sources -V and +V, respectively.

The recess formation step of Figure 1(b) is optional, i.e., the brazing compound can be spread directly on the upper surface of dielectric 30 to form one or more patches. Forming the recesses 31,32, however, eliminates the air gap that would otherwise form between dielectrics 30,33. This air gap could contain undesirable impurities.

In an alternative embodiment, the wires 37,38 can be formed to protrude from electrodes 11,13 outwardly rather than downwardly.

## Claims

1. A method of manufacturing an electrostatic chuck, said method comprising the steps of:
forming at least one patch of brazing compound on a first surface of a generally flat first dielectric plate;
placing a second dielectric plate, thinner than said first dielectric plate, onto the patched first dielectric plate;
heating the assembly consisting of the first and second dielectric plates and the brazing compound to a temperature above the melting point of the brazing compound;
cooling the assembly so that the first and second dielectric plates are brazed together; and
connecting each cooled patch to a voltage source.

2. A method as claimed in claim 1 further comprising, prior to the forming step, the step of making a recess in said first surface of said first dielectric plate to accommodate each patch of brazing compound.

3. A method as claimed in claim 1 wherein the first and second dielectric plates are fabricated of materials not containing polar molecules that are free to move in response to energization of the voltage source.

## Patentansprüche

1. Verfahren zur Herstellung einer elektrostatischen Haltevorrichtung, wobei das Verfahren die Schritte umfaßt:
Bilden von zumindest einem Fleck aus Lötmittel auf einer ersten Oberfläche einer allgemein flachen ersten dielektrischen Platte,
Anordnen einer zweiten dielektrischen Platte, die dünner als die erste dielektrische Platte ist, auf der mit Flecken versehenen ersten dielektrischen Platte,
Heizen der Anordnung, die aus den ersten und zweiten dielektrischen Platten und dem Lötmittel besteht, auf eine Temperatur über dem Schmelzpunkt des Lötmittels,
Abkühlen der Anordnung derart, daß die ersten und zweiten dielektrischen Platten miteinander verlötet werden, und
Verbinden von jedem abgekühlten Fleck mit einer Spannungsquelle.

2. Verfahren nach Anspruch 1, außerdem umfassend vor dem Ausbildungsschritt, den Schritt, eine Eintiefung in der ersten Oberfläche der ersten dielektrischen Platte bereitzustellen, um jeden Fleck aus Lötmittel aufzunehmen.

3. Verfahren nach Anspruch 1, wobei die ersten und zweiten dielektrischen Platten aus Materialien hergestellt werden, die keine polaren Moleküle enthalten, die sich ansprechend auf eine Energieversorgung durch eine Spannungsquelle frei bewegen können.

## Revendications

1. Procédé de fabrication d'un plateau électrostatique, ledit procédé comprenant les étapes de :
formation d'au moins une plaquette de composé de brasage sur une première surface d'une première plaque diélectrique de forme générale plate ;
mise en place d'une deuxième plaque diélectrique, plus mince que ladite première plaque diélectrique, sur la première plaque diélectrique munie d'une plaquette ;
chauffage de l'ensemble constitué des première et deuxième plaques et du composé de brasage à une température supérieure au point de fusion du composé de brasage ;
refroidissement de l'ensemble afin que les première et deuxième plaques diélectriques soient brasées ensemble ; et
connexion de chaque plaquette refroidie à une source de tension.

2. Procédé selon la revendication 1 comprenant en outre, avant l'étape de formation, l'étape de fabrication d'une cavité dans ladite première surface de ladite première plaque diélectrique pour recevoir chaque plaquette de composé de brasage.

3. Procédé selon la revendication 1, dans lequel les première et deuxième plaques diélectriques sont faites en matériau ne contenant pas de molécules polaires qui sont libres de se déplacer en réponse à une activation de la source de tension.
